# EUROPEAN PATENT SPECIFICATION

(11) **EP 1 397 211 B1**
(45) Date of publication and mention of the grant of the patent: **27.12.2006**
(21) Application number: 01953170.6
(22) Date of filing: 08.06.2001
(51) Int. Cl.: B01L 3/00

(54) **METHOD OF MANUFACTURING A MICROFLUIDIC STRUCTURE, IN PARTICULAR A BIOCHIP, AND STRUCTURE OBTAINED BY SAID METHOD**
METHODE ZUR HERSTELLUNG EINER MIKROFLÜSSIGKEITSSTRUKTUR, INSBESONDERE EINES "BIOCHIPS", UND DAMIT ERZEUGTE STRUKTUR
PROCEDE DE FABRICATION D'UNE STRUCTURE MICROFLUIDIQUE, EN PARTICULIER UNE PUCE A ADN ET STRUCTURE OBTENUE PAR LEDIT PROCEDE

(43) Date of publication of application: 17.03.2004
(73) Proprietor: CENTRE NATIONAL DE LA RECHERCHE SCIENTIFIQUE, 75794 Paris Cedex 16 (FR)
(72) Inventor: LE PIOUFLE, Bruno, F-75014 Paris (FR); FUJITA, Horoyuki, Tokyo 1711-0041 (JP); TAMIYA, Eiichi, School of Materials Science, Tatsunokuchi, Ishikawa 923-1292 (JP); GRISCOM, Laurent, F-35000 Rennes (FR); DEGENAAR, Patrick, NL-1075 Amsterdam Zvid (JP)
(74) Representative: Bolinches, Michel Jean-Marie
(86) International application number: PCT/EP2001/007058
(87) International publication number: WO 2002/100542

(56) References cited:
- WO-A-00/60352
- DE-A- 19 948 087
- US-A- 5 376 252
- US-A- 5 932 315
- US-A- 6 039 897
- P. DEGENAAR ET AL.: "A method of micrometer resolution patterning of primary culture neurons for SPM Analysis" [Online] 12 April 2001 (2001-04-12) , THE JOURNAL OF BIOCHEMISTRY XP002183338 130 Retrieved from the Internet: <URL: http://jb.bcasj.or.jp/130-3/3faaodtx.htm> [retrieved on 2001-11-16] page 369 -page 370
- S. ZHANG ET AL.: "Biological surface engineering: a simple system for cell pattern formation" [Online] 28 July 1998 (1998-07-28) , BIOMATERIALS XP002183339 20 Retrieved from the Internet: <URL: http://147.46.94.112/journal/sej/j_b/data/ bio9907v20i1307.pdf> [retrieved on 2001-11-16] page 1214, paragraph 2.3.

## Description

The present invention relates to a method of manufacturing a microfluidic structure, in particular a biochip, and to a structure obtained by said method.

There is increasing interest in the biological and medical research community to integrate micromachined structures and microelectronics for biological measurements or micromanipulation. Microstructures for rapid separation and isolation of cells in biological assays are of great interest for research laboratories and pharmaceutical industry. For instance, in the case of neural cultures, controlled guidance of neurons is a desired feature of a biochip for the research and understanding of complex developing neural networks.

The new field of microfluidics is turning out to be a boon for the biotech industry in providing inexpensive, biologically compatible and disposible tools for handling small quantities of biological materials and chemicals. Microfluidic structures have become essential in techniques such as PCR and capillary electrophoretic cell manipulation. These microfluidic tools are often made using a variant of poly-dimethylsiloxane (PDMS) in which the channels are typically made through micromoulding and placement on a glass substrate. These structures, however, are often closed structures limited to two dimensions with an input and an output end. Some more complex multi level structures can be made through stacking multiple layers of microfluidics, but these are often difficult to align and are do not offer truly micro scale alignment.

An object of the invention is to conceive a new microfluidic structure, in particular a biochip, said microfluidic structure having a three-dimensional geometry.

To this end, the invention provides a method of manufacturing a microfluidic structure, in particular a biochip, said method consisting :
- in a first step, spin-coating a first resist layer on a face of a substrate, and baking said first layer;
- in a second step, submitting the first resist layer to UV exposure through a mask to define at least the geometry of micro-grooves;
- in a third step, without developing the first layer, spin-coating a second resist layer on the first layer, and baking said second layer;
- in a fourth step, submitting the second layer to UV exposure through a mask for defining at least the geometry of vertical micro-wells; and
- in a final step, developing said layers to obtain a three-dimensional micro-mould for use in molding a membrane of a polymer material injected between the micro-mould and a plate pressed onto the top of the micro-mould.

By way of example, the method consists in injecting the polymer material between the micro-mould and a plate pressed onto the top of the micro-mould, and in baking the polymer material at a temperature of about 70°C during approximatively one hour, in order to form said membrane with said micro-wells crossing the membrane and said micro-grooves located on one of the membrane faces.

Advantageously, the method consists in using a polymer material having hydrophobic properties to form the membrane, and in using a substrate made of a material having also hydrophobic properties, in order to obtain a natural adherence between the membrane and the substrate.

By way of example, the method consists in using a polymer material such as a polydimethylsiloxane (PDMS) to form the membrane.

Advantageously, the method consists in rendering hydrophilic the micro-wells and the micro-grooves or the micro-channels of the membrane by a treatment such as an oxygen plasma treatment.

In particular, the method consists in setting in contact said membrane with a glass substrate before applying the oxygen plasma treatment, the face of the membrane in contact with the glass substrate keeping its hydrophobic properties.

In a first implementation, the method consists in obtaining a silicon micro-mould by an Inductive Coupled Plasma Reactive Ion Etching (ICP RIE), said etching being tri-dimensional and requiring at least a first etching to form the micro-grooves or micro-channels and a second etching to form the micro-wells.

Advantageously, in said first implementation, the method consists in exposing the obtained silicon micro-mould to a CHF3 plasma treatment in order to minimize the adherence between the surface of the obtained silicon micro-mould and the membrane to be molded in said silicon micro-mould.

In a second implementation, the method consists in obtaining a resist micro-mould by at least two successive UV exposures through a mask and without intermediate developing, the first exposure defining means for forming the micro-grooves and the second exposure, after spin-coating a second resist layer, defining means for forming the micro-wells.

Advantageously, in said second implementation, said method consists in using a resist such as a SU8.

The invention relates also to a three-dimensional microfluidic structure as obtained by the method according to the invention.

Combination of micromachined biochips to three-dimentional structured microfluidic membranes will lead to highly parallelised bio-microsystems, capable to isolate single cells , or small groups of living cells, in an array of minimum several hundreds of wells, for sensing or manipulation purposes. These so called cell-biochips have great interest for industry or for the research.

In particular, the invention is useful where a great number of parallel manipulations have to be held on living cells. The proposed three-dimensional microfluidic structure, arranging cells in an array of micro-wells, underground-connected by means of microfluidic channels may have applications for:
- Pharmacology and high output screening where highly parallelized techniques are absolutely necessary ; in the three-dimensional microfluidic structure, the open wells containing single cells are connected to underground microfluidic network which permits the addressing of pharmaceutics products (very few products, fast, highly paralelized),
- Gene transfer, as nowadays transfection techniques are not efficient, and the cell-chip of the invention could be a key device, being capable to isolate single cells as an array for analysis and optimization of the transfection,
- ex-vivo culture and guided growth of neurons, for fundamental research, and
- cell bio-sensors (measurement of environment effects and pollution effects on cells).

Other characteristics, advantages, and details of the invention appear from the following explanatory description with reference to the accompanying drawings, given purely by way of example, and in which :
- Figure 1 is fragmentary perspective view of a three-dimensional microfluidic structure manufactured according to the method of the invention, and
- Figure 2a to 2e are schematic views for illustrating the method of the invention according to a preferred implementation.

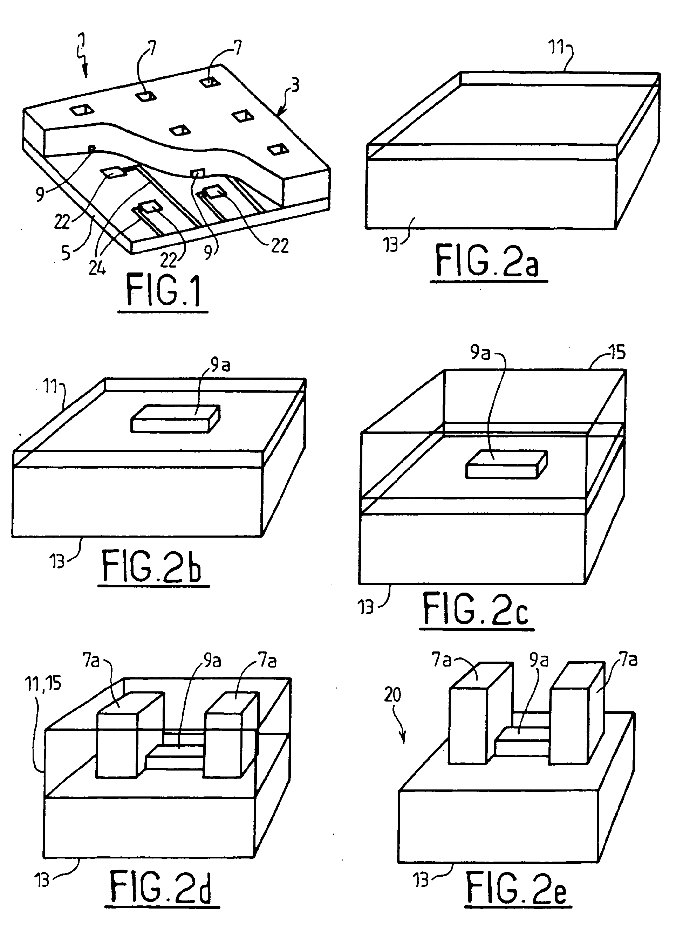

A three-dimensional microfluidic structure I according to one embodiment of the invention is illustrated on figure 1.

The three-dimensional microfluidic structure 1 is formed by at least a membrane 3 and a substrate 5. The membrane 3 incorporates at least an array of vertical micro-wells 7 crossing said membrane 3, and longitudinal micro-grooves 9 located on one of the membrane faces and interconnecting at least some of said micro-wells 7.

This three-dimensional microfluidic structure 1 is directly obtained by molding according to a first or second technique.

The first technique permits to obtain a silicon micro-mould, by means of deep plasma etching (ICP RIE Inductive Coupled Plasma Reactive Ion Etching). The etching has to be tri-dimensional, and at least two-levels etching are required: one for the micro-channels and one for the open wells.

Advantageously, the surface of the three-dimensional microfluidic structure is covered by a carbonic polymer, obtained by means of exposing the surface to a CHF3 plasma, in order to minimize the adherence between the surface of the obtained micro-mould and the micro-membrane to be molded.

The second technique permits to obtain a thick resist mould, the resist used being SU8 for example. In general, at least two successive UV exposures are required through a mask, without any intermediate developing, permit to define the three-dimensional geometry of the membrane. Concretely, at least a first exposure permits to define the geometry of the micro-channels, and a second exposure, after spin-coating a second resist layer, permits to define the geometry of the micro-wells. The alignment between the two geometries can be made without developing the resist of successive layers: indeed the UV exposure changes the refraction index of exposed resist, the exposed surfaces becoming thus visible. A more complex structure could be obtained by spin-coating and UV exposing of successive layers. The total geometry of the micro-mould is then developed in a specific developer.

In particular, the method consists in a first step as illustrated on figure 2a, to spin-coat a first layer 11 of SU8 on a face of a substrate 13. The thickness of this first layer 11 is of about 20µm to 300µm, this thickness being defined by the speed and the duration of the spin-coating operation. The first layer 11 is then baked.

In a second step as illustrated on figure 2b, the first resist layer 11 is submitted to a UV exposure through a mask (not represented) to define at least the geometry 9a of the micro-grooves 9.

In a third step as illustrated on figure 2c, without developing the first layer 11, a second resist layer 15 is spin-coated on the first layer 11. The thickness of the second layer 15 is also defined by the speed and the duration of this spin-coating operation, the thickness being of about 20µm to 300µm. The second layer 15 is then baked.

In a fourth step as illustrated on figure 2d, the second resist layer 15 is submitted to a UV exposure through a mask (non represented) for defining at least the geometry 7a of the micro-wells 7.

In a final step as illustrated on figure 2e, the structure is developed in a manner known per se to obtain a three-dimensional micro-mould 20 including means for defining longitudinal micro-grooves 9 and vertical micro-wells 7. The alignment between the layers 11 and 15 is performed owing to the change of the refractive index of the exposed surfaces which become visible by microscopy.

The three-dimensional micro-mould 20, obtained by one of the two methods presented, is then used to mould a membrane made of a polymer material, such as a polydimethylsiloxane (PDMS) having hydrophobic properties. The polymer (PDMS) is injected between the mould and a polyacrylic plate, pressed onto the top of the mould structure. After one hour of 70°C baking, the membrane is formed: micro-wells are crossing the membrane, and micro-channels are formed on one of the membrane faces.

In a first embodiment, the micro-molded membrane can constitute a three-dimensional microfluidic structure.

In a second embodiment, as illustrated on figure 1, the micro-molded membrane 3 is associated with the substrate 5.

By way of example, the substrate 5 can be constituted by an electronic chip comprising at least micro-electrodes 22 which are connected to an electronic circuitry through micro-conductors 24. The micro-electrodes 22 can be golded and, advantageously, the substrate 5 is made of a material having hydrophobic properties.

The membrane is directly placed onto the electronic chip, under a microscope, so that micro-wells can be aligned onto the electrodes of the electronic-chip. The membrane and the electronic-chip adhere together due to their hydrophobic properties.

Advantageously, the micro-conductors 24 and the substrate 5 are transparent, in order to be able to visualize the microfluidic structure through microscopy. For instance, the substrate 5 is formed by a glass plate, and the micro-conductors 24 are in ITO.

In general, the materials are chosen in order to ensure the biocompatibility of the microfluidic structure with biological substances and living cells to be treated by the microfluidic structure. If the materials used do not satisfy the condition of biocompatibility, said materials are treated accordingly, i.e. with an appropriate coating.

Micro-wells and micro-channels have to be rendered hydrophilic, in order to permit to cells to enter into the micro-wells, and to permit to aqueous bio-chemical compounds to enter into the micro-channels. In the other hand, the micro-membrane surface facing the electronic chip has to keep its hydrophobic properties in order to keep adherence between both surfaces. For example, an oxygen plasma treatment is applied to the membrane while maintaining this one stuck onto a glass substrate (different to the electronic chip substrate): the plasma penetrates and modifies the properties of micro-wells and micro-channels, rendering their surfaces hydrophilic.

In general, in a three-dimensional microfluidic structure obtained by the method according to the invention, the micro-wells of the membrane have dimensions varying from 30µm to 100µm, the membrane has a thickness of about 40µm to 300µm. Furthermore, the micro-channels have a rectangular section with sizes vary from 10µm to 300µm, and the number of micro-wells can be comprised in a range of 100 to 10 000 / cm².

## Claims

1. A method of manufacturing a microfluidic structure, in particular a biochip, said method consisting :
- in a first step, spin-coating a first resist layer (11) on a face of a substrate (13), and baking said first layer (11);
- in a second step, submitting the first resist layer (11) to UV exposure through a mask to define at least the geometry (9a) of micro-grooves (9);
- in a third step, without developing the first layer (11), spin-coating a second resist layer (15) on the first layer (11), and baking said second layer (15);
- in a fourth step, submitting the second layer (15) to UV exposure through a mask for defining at least the geometry (7a) of vertical micro-wells (7); and
- in a final step, developing said layers (11, 15) to obtain a three-dimensional micro-mould (20) for use in molding a membrane of a polymer material injected between the micro-mould and a plate pressed onto the top of the micro-mould.

2. A method according to claim 1, wherein the first (11) and second layer (15) are made of a SU8 material.

3. A method according to any of the preceding claims, consisting in baking the polymer material at a temperature of about 70°C during approximatively one hour, in order to form said membrane with said micro-wells crossing the membrane and said micro-grooves on one of the membrane faces.

4. A method according to any of the preceding claims, consisting in using a polymer material having hydrophobic properties, in order to obtain a natural adherence between the membrane and the substrate.

5. A method according to claim 4, consisting in using a polymer material such as a polydimethylsiloxane (PDMS) to form the membrane.

6. A method according to any of the preceding claims, consisting in rendering hydrophilic the micro-wells and the micro-grooves or the micro-channels of the membrane by a treatment such as an oxygen plasma treatment.

7. A method according to claim 6, consisting in setting in contact said membrane with a glass substrate before applying the oxygen plasma treatment, the face of the membrane in contact with the glass substrate keeping its hydrophobic properties.

8. A method according to any of the preceding claims, consisting in obtaining a silicon micro-mould by an Inductive Coupled Plasma Reactive Ion Etching (ICP RIE), said etching being tri-dimensional and requiring at least a first etching to form the micro-grooves or micro-channels and a second etching to form the micro-wells.

9. A method according to claim 8, consisting in exposing the obtained silicon micro-mould to a CHF3 plasma treatment in order to minimize the adherence between the surface of the obtained silicon micro-mould and the membrane to be molded in said silicon micro-mould.

10. A microfluidic structure as manufactured by the method according to any of the preceding claims, said structure comprising at least a membrane made of a polymer material and including at least micro-wells and micro-grooves or micro-channels interconnecting said micro-wells, said membrane constituting a three-dimensional micro-structure, **characterized in that** the micro-wells of the membrane have dimensions varying from 30µm to 100µm, **in that** the membrane has a thickness of about 40µm to 300µm, **in that** the micro-channels have a rectangular section which sizes vary from 10µm to 300µm and **in that** the number of micro-wells can be comprised in a range of 100 to 10 000/cm².

11. A microfluidic structure according to claim 10, **characterized in that** the material(s) used for the microfluidic structure is biocompatible or rendered compatible by a specific coating, with the biological substances and living cells to be treated by said microfluidic structure.

## Patentansprüche

1. Verfahren zum Herstellen einer Mikrofluidstruktur, insbesondere eines Biochips, umfassend:
- Rotationsbeschichten einer ersten Resistschicht (11) auf eine Seite eines Substrats (13) und Backen der ersten Schicht (11) in einem ersten Schritt;
- Belichten der ersten Resistschicht (11) mit UV-Strahlung durch eine Maske zur Definition von wenigstens der Geometrie (9a) von Mikronuten (9) in einem zweiten Schritt;
- Rotationsbeschichten einer zweiten Resistschicht (15) auf die erste Schicht (11), ohne die erste Schicht (11) zu entwickeln, und Backen der zweiten Schicht (15) in einem dritten Schritt;
- Belichten der zweiten Resistschicht (15) mit UV-Strahlung durch eine Maske zur Definition von wenigstens der Geometrie (7a) von vertikalen Mikrovertiefungen (7) in einem vierten Schritt; und
- Entwickeln der Schichten (11, 15) in einem letzten Schritt, zum Erhalt einer dreidimensionalen Mikroform (20) zur Verwendung beim Giessen einer Membran aus einem Polymermaterial, das zwischen der Mikroform und einer auf die Oberseite der Mikroform gepressten Platte injiziert wurde.

2. Verfahren gemäß Anspruch 1, bei dem die erste (11) und die zweite Schicht (15) aus einem SU8-Material hergestellt sind.

3. Verfahren gemäß einem der vorhergehenden Ansprüche, bestehend im Backen des Polymermaterials bei einer Temperatur von ungefähr 70 °C während angenähert einer Stunde zum Bilden der Membran mit den Mikrovertiefungen, die die Membran durchqueren und der Mikronute auf einer der Seiten der Membran.

4. Verfahren gemäß einem der vorhergehenden Ansprüche, bestehend in der Verwendung eines Polymermaterials mit hydrophoben Eigenschaften zum Erhalt einer natürlichen Haftung zwischen der Membran und dem Substrat.

5. Verfahren gemäß Anspruch 4, bestehend in der Verwendung eines Polymermaterials, wie Polydimethylsiloxan (PDMS), zum Bilden der Membran.

6. Verfahren gemäß einem der vorhergehenden Ansprüche, bestehend im Hydrophilisieren der Mikrovertiefungen und der Mikronute oder Mikrokanäle der Membran durch eine Behandlung wie Sauerstoff-Plasmabehandlung.

7. Verfahren gemäß Anspruch 6, bestehend in einem Inkontaktsetzen der Membran mit einem Glassubstrat vor Anwenden der Sauerstoff-Plasmabehandlung, wobei die Seite der Membran in Kontakt mit dem Glasssubstrat ihre hydrophoben Eigenschaften beibehält.

8. Verfahren gemäß einem der vorhergehenden Ansprüche, bestehend im Erhalten einer Silicium-Mikroform durch ein reaktives Ionenätzen mit induktiv gekoppeltem Plasma (ICP RIE), wobei das Ätzen dreidimensional erfolgt und wenigstens ein erstes Ätzen zum Bilden der Mikronute oder Mikrokanäle und ein zweites Ätzen zum Bilden der Mikrovertiefungen erfordert.

9. Verfahren gemäß Anspruch 8, bestehend im Aussetzen der erhaltenen Silizium-Mikroform unter eine CHF₃-Plasmabehandlung zum Minimieren der Haftung zwischen der Oberfläche der erhaltenen Silicium-Mikroform und der in der Mikroform zu gießenden Membran.

10. Mikrofluidstruktur, wie nach einem Verfahren gemäß einem der vorhergehenden Ansprüche hergestellt, wobei die Struktur wenigstens eine aus einem Polymermaterial hergestellte Membran umfasst und wenigstens Mikrovertiefungen und Mikronute oder Mikrokanäle einschließt, die die Mikrovertiefungen miteinander verbinden, wobei die Membran eine dreidimensionale Mikro-Struktur darstellt, **dadurch gekennzeichnet, dass** die Mikrovertiefungen der Membran von 30 µm bis 100 µm variierende Dimensionen besitzt, dass die Membran eine Dicke von ungefähr 40 µm bis 300 µm besitzt, dass die Mikrokanäle einen rechteckigen Abschnitt besitzen, dessen Größen von 10 µm bis 300 µm variieren, und dass sie Anzahl der Mikrovertiefungen in einem Bereich von 100 bis 10000/cm² umfasst sein können.

11. Mikrofluidstruktur nach Anspruch 10, **dadurch gekennzeichnet, dass** das (die) für die Mikrofluidstruktur verwendete(n) Material(ien) biokompatibel oder durch eine spezifische Beschichtung mit den biologischen Substanzen und lebenden Zellen, die von der Mikrofluidstruktur behandelt werden sollen, biokompatibel gemacht wird (werden).

## Revendications

1. Procédé de fabrication d'une structure microfluidique, en particulier une puce à ADN, ledit procédé consistant à :
- dans une première étape, déposer par centrifugation une première couche de réserve (11) sur une face d'un substrat (13) et cuire ladite première couche (11) ;
- dans une deuxième étape, soumettre la première couche de réserve (11) à une exposition aux UV au travers d'un masque pour définir au moins la géométrie (9a) de micro-rainures (9) :
- dans une troisième étape, sans développer la première couche (11), déposer par centrifugation une deuxième couche de réserve (15) sur la première couche (11) et cuire ladite deuxième couche (15) ;
- dans une quatrième étape, soumettre la deuxième couche (15) à une exposition aux UV au travers d'un masque pour définir au moins la géométrie (7a) de micro-puits verticaux (7), et
- dans une étape finale, développer lesdites couches (11, 15) pour obtenir un micro-moule (20) tridimensionnel, destiné à être utilisé dans le moulage d'une membrane d'un matériau polymère injecté entre le micro-moule et une plaque pressée sur le sommet du micro-moule.

2. Procédé selon la revendication 1 dans lequel la première couche (11) et la deuxième couche (15) sont faites dans un matériau SU8.

3. Procédé selon l'une quelconque des revendications précédentes consistant à cuire le matériau polymère à une température d'environ 70°C pendant approximativement une heure afin de former ladite membrane avec lesdits micro-puits traversant la membrane et lesdites micro-rainures sur l'une des faces de la membrane.

4. Procédé selon l'une quelconque des revendications précédentes consistant à utiliser un matériau polymère ayant des propriétés hydrophobes afin d'obtenir une adhérence naturelle entre la membrane et le substrat.

5. Procédé selon la revendication 4 consistant à utiliser un matériau polymère tel que le polydiméthylsiloxane (PDMS) pour former la membrane.

6. Procédé selon l'une quelconque des revendications précédentes consistant à rendre hydrophiles les micro-puits et les micro-rainures ou les micro-canaux de la membrane par un traitement tel qu'un traitement sous plasma d'oxygène.

7. Procédé selon la revendication 6 consistant à mettre ladite membrane en contact avec un substrat de verre avant d'appliquer le traitement sous plasma d'oxygène, la face de la membrane en contact avec le substrat de verre gardant ses propriétés hydrophobes.

8. Procédé selon l'une quelconque des revendications précédentes consistant à obtenir un micro-moule en silicium par une gravure par ions réactifs à plasma inductif (ICP RIE), ladite gravure étant tridimensionnelle et nécessitant au moins une première gravure pour former les micro-rainures ou micro-canaux et une deuxième gravure pour former les micro-puits.

9. Procédé selon la revendication 8 consistant à exposer le micro-moule en silicium obtenu à un traitement par plasma CHF₃ afin de minimiser l'adhérence entre la surface du micro-moule en silicium obtenu et la membrane à mouler dans ledit micro-moule de silicium.

10. Structure microfluidique telle que fabriquée par le procédé selon l'une quelconque des revendications précédentes, ladite structure comprenant au moins une membrane faite d'un matériau polymère et incluant au moins des micro-puits et des micro-rainures ou des micro-canaux interconnectant lesdits micro-puits, ladite membrane constituant une microstructure tridimensionnelle, **caractérisée en ce que** les micro-puits de la membrane ont des dimensions variant de 30 µm à 100 µm, **en ce que** la membrane a une épaisseur d'environ 40 µm à 300 µm, **en ce que** les micro-canaux ont une section rectangulaire dont les tailles varient de 10 µm à 300 µm et **en ce que** le nombre de micro-puits peut être compris dans une gamme de 100 à 10 000 /cm².

11. Structure microfluidique selon la revendication 10 **caractérisée en ce que** le ou les matériaux utilisés pour la structure microfluidique sont biocompatibles ou rendus compatibles par un revêtement spécifique avec les substances biologiques et les cellules vivantes devant être traitées par ladite structure microfluidique.
